# EUROPEAN PATENT SPECIFICATION

(11) **EP 2 866 297 B1**
(45) Date of publication and mention of the grant of the patent: **06.01.2021**
(21) Application number: 13809151.7
(22) Date of filing: 26.06.2013
(51) Int. Cl.: H01M 14/00, H01L 31/04, H01G 9/20

(54) **DYE-SENSITIZED SOLAR CELL**
FARBSTOFFSENSIBILISIERTE SOLARZELLE
CELLULE SOLAIRE À COLORANT

(30) Priority: 26.06.2012 JP 2012143571; 03.10.2012 JP 2012221749; 16.03.2013 JP 2013054454
(43) Date of publication of application: 29.04.2015
(73) Proprietor: Nippon Chemi-Con Corporation, Tokyo 141-8605 (JP)
(72) Inventor: MACHIDA, Kenji, Tokyo 141-8605 (JP); KAMIYAMA, Nozomu, Tokyo 141-8605 (JP); TAKEUCHI, Shingo, Tokyo 141-8605 (JP); TAMAMITSU, Kenji, Tokyo 141-8605 (JP)
(74) Representative: Staudt, Hans-Peter
(86) International application number: PCT/JP2013/067435
(87) International publication number: WO 2014/003027

(56) References cited:
- EP-A1- 2 693 505
- WO-A1-2011/108254
- JP-A- 2005 116 301
- JP-A- 2006 054 449
- JP-A- 2006 066 549
- JP-A- 2006 351 289
- JP-A- 2007 128 757
- JP-A- 2007 242 932
- JP-A- 2011 204 546
- JP-A- 2012 216 673

## Description

### BACKGROUND OF THE INVENTION

### 1. Field of the Invention

The present invention relates to a dye-sensitized solar cell that has excellent thermal resistance, a high fill factor value and high photoelectric conversion efficiency.

### 2. Description of the Related Art

Compared with a silicon solar cell and a compound solar cell, a dye-sensitized solar cell has advantages such as no resource constraints, a low production cost due to inexpensive raw materials and a simple production method, and a capability of being lightweight and flexible. By virtue of these advantages, the dye-sensitized solar cell arouses high expectations as a next-generation solar cell.

The dye-sensitized solar cell has a structure in which an electrolyte layer containing a paired oxidized species and reduced species is between a negative electrode with a semiconductor layer containing a pigment as a photosensitizer and a positive electrode with a catalyst layer that converts the oxidized species in the electrolyte layer to reduced species. Generally, an electrode in which an oxide semiconductor layer with a pigment such as a ruthenium complex is formed on a transparent electrode in which a vapor deposition layer of semiconductive ceramics such as tin-doped indium oxide (ITO) and fluorine-doped tin oxide (FTO) is formed on the surface of a transparent substrate such as glass is used as the negative electrode, and an electrode in which platinum (Pt) is attached to a substrate such as the above-mentioned transparent electrode or steel by the sputtering method or the vacuum deposition method is used as the positive electrode. When light is irradiated onto the pigment of the semiconductor layer through the transparent electrode, the pigment absorbs light energy, becomes excited and releases an electron toward the semiconductor. The released electron moves from the semiconductor layer to the transparent electrode, and furthermore, moves from the transparent electrode to the positive electrode through an external circuit. Then, the oxidized species (for example, I₃⁻) in the electrolyte layer is converted to the reduced species (for example, I⁻) by receiving an electron from the positive electrode by the action of the Pt catalyst layer of the positive electrode, and furthermore, the reduced species (for example, I⁻) is converted into the oxidized species (for example, I₃⁻) by releasing an electron toward the pigment.

The Pt catalyst layer of the positive electrode is expensive though it has excellent catalytic activity to convert the oxidized species of the electrolyte layer into the reduced species. Moreover, the Pt catalyst layer has disadvantages in that the manufacturing facilities required are expensive because a vacuum process is required for manufacturing it, the manufacturing process is complex, and the quantity output is low. Moreover, it has a further disadvantage in that its durability against I⁻ ions is not enough when water exists. Therefore, a conductive material that can substitute the Pt catalyst layer is required, and conductive polymer layers, especially conductive polymer layers composed of a polystyrene sulfonate of poly(3,4-ethylenedioxythiophene) have been frequently considered (hereinafter 3,4-ethylenedioxythiophene is referred to as "EDOT", poly(3,4-ethylenedioxythiophene) as "PEDOT", polystyrene sulfonic acid as "PSS", and a polystyrene sulfonate of poly(3,4-ethylenedioxythiophene) as "PEDOT:PSS"). Since a layer of the conductive polymer such as PEDOT:PSS is manufactured by a wet process, the required manufacturing facilities are less expensive than those for a Pt catalyst layer and the manufacturing process is simpler than that for a Pt catalyst layer. Moreover, because a conductive polymer layer is flexible and can be formed on a curved surface, its range of application may increase.

For example, Non-patent Document 1 (Electrochemistry 71, No. 11 (2003) 944-946) reports the result of selecting an electrode with three kinds of conductive polymer layers, namely a PEDOT:PSS electrode, a polyaniline electrode and a polypyrrole electrode, measuring a cyclic voltammogram in an electrolyte including an I⁻/I₃⁻ redox pair, and comparing it with a cyclic voltammogram of a Pt electrode. According to the report of this Non-patent Document 1, a reduction wave from I₃⁻ to I⁻ was clearly found in the cyclic voltammogram of the Pt electrode, while almost no reduction wave from I₃⁻ to I⁻ was found in the cyclic voltammogram of the PEDOT: PSS electrode and the polypyrrole electrode, and in the cyclic voltammogram of the polyaniline electrode no oxidation-reduction wave was found. In a dye-sensitized solar cell, this reduction wave from I₃⁻ to I⁻ is especially important because sufficient regeneration of I⁻ is necessary to obtain a dye-sensitized solar cell with a satisfactory rating. However, even the PEDOT:PSS electrode, and needless to say the polyaniline electrode and the polypyrrole electrode, did not show a clear reduction wave and did not have a satisfactory rating as the positive electrode of the dye-sensitized solar cell.

The usage of a PEDOT layer including a dopant other than a PSS anion has also been considered. Patent Document 1 (JP 2008-16442 A) discloses a dye-sensitized solar cell having a negative electrode with a titanium oxide layer containing a pigment, an electrolyte layer composed of a 3-methoxypropionitrile solution containing bis(5-methyl-1, 3, 4-thiadiazolyl)2-disulfide and 5-methyl-2-mercapto-1, 3, 4-thiadiazole salt, which form a redox pair, and a positive electrode with a PEDOT layer obtained by chemical polymerization of EDOT with iron(III) tris(p-toluenesulfonate) as an oxidizing agent. This solar cell has a high fill factor value compared with a solar cell that uses a positive electrode with a Pt layer instead of the positive electrode with the PEDOT layer (see working example 1 and comparative example 4 of this document), explaining that this results from the fact that the PEDOT layer has more excellent catalytic activity against the redox pair than the Pt layer. Also, when an iodine-based redox pair is used instead of the redox pair, a solar cell having a positive electrode with the PEDOT layer and a solar cell having a positive electrode with the Pt layer shows almost the same fill factor value and photoelectric conversion efficiency (see comparative example 1 and comparative example 3 of this document).

Patent documents 2 and 3 disclosed dye sensitized solar cells comprising polythiophene polymers in the counter electrode.

Patent document 4 discloses a polymerization fluid and a process of making an electrode using said polymerization fluid.

### PRIOR ARTS DOCUMENTS

### Patent Documents

Patent Document 1: JP 2008-16442 A
Patent Document 2: JP 2006 351289 A
Patent Document 3: JP 2005 116301 A
Patent Document 4: WO 2011/108254 A1

### Non-Patent Documents

Non-patent Document 1: Electrochemistry 71, No. 11 (2003) 944-946

### BRIEF SUMMARY OF THE INVENTION

### 1. Problems to be Solved by the Invention

As mentioned above, high catalytic activity to convert an oxidized species in an electrolyte layer into a reduced species is required for a conductive polymer layer of a positive electrode. Further, because it is envisaged that each component of a solar cell may experience a high temperature in the manufacturing process of a solar cell and in a situation in which the solar cell is used outdoors in intense heat, heat resistance is required for each component of the solar cell. However, a PEDOT:PSS layer and a PEDOT layer with p-toluenesulfonate anion as a dopant, which were hitherto considered, did not have satisfactory heat resistance.

In contrast, the applicants, in WO2012/133858A1 and WO2012/133859A1, which were published after filing an application that was established as the basis for claiming priority of the present application, reported that a conductive polymer layer comprising a polymer derived from at least one kind of monomer selected from a group consisting of 3,4-disubstituted thiophenes (hereinafter 3,4-disubstituted thiophene is referred to as "substituted thiophene") and an anion as a dopant to the polymer generated from at least one organic non-sulfonate compound having an anion with the molecular weight of 200 or more, has excellent thermal resistance property and excellent catalytic activity to convert an oxidized species in an electrolyte layer into a reduced species, and further reported that heat resistance further improves by restricting the density of the conductive polymer layer to the range of 1.15 to 1.80 g/cm³. Here, the "organic non-sulfonate compound" means an organic compound that does not have a sulfonic acid group and/or a sulfonic acid salt group.

The objective of the present invention is, based on the above-mentioned findings, to provide a dye-sensitized solar cell that has excellent heat resistance, a high fill factor and high light conversion efficiency.

### 2. Means for Solving Problems

The inventors, upon keen examination, found that, by composing a dye-sensitized solar cell with the thickness of a conductive polymer layer of a positive electrode set as 100 nm or more, a dye-sensitized solar cell that has a higher fill factor than a conventional dye-sensitized solar cell using a positive electrode with a Pt catalyst layer can be obtained.

Therefore, the present invention provides a dye-sensitized solar cell comprising: a negative electrode having a semiconductor layer with a pigment as a photosensitizer; an electrolyte layer located on the semiconductor layer of the negative electrode having a paired oxidized species and reduced species; and a positive electrode located on the electrolyte layer having a conductive polymer layer that acts as a catalyst to convert the oxidized species into the reduced species, in which the conductive polymer layer in the positive electrode comprises: a polymer derived from at least one monomer selected from the substituted thiophenes; and an anion as a dopant to the polymer generated from at least one organic non-sulfonate compound having an anion with the molecular weight of 200 or more, and the thickness of the conductive polymer layer is within the range of 100 to 10000 nm. Since the photoelectric conversion efficiency of the dye-sensitized solar cell is proportionate to the fill factor value, a dye-sensitized solar cell with high photoelectric conversion efficiency can be obtained by the present invention.

The conductive polymer layer comprises, as a dopant, an anion generated from an organic non-sulfonate compound having an anion with the molecular weight of 200 or more. An anion generated from an inorganic compound, or even in the case of an organic compound, an anion generated from a compound with a sulfonic acid group and/or a sulfonic acid salt group, or even in an organic compound without a sulfonic acid group and/or a sulfonic acid salt group, an anion generated from a compound in which the molecular weight of the anions is less than 200 does not produce a conductive polymer layer with excellent heat resistance (see WO2012/133858A1 and WO2012/133859A1). Among the organic non-sulfonate compounds in which the molecular weight of the anions is 200 or more, a compound selected from borodisalicylic acid, its salts, and a sulfonylimidic acid of the formula (I) or the formula (II) 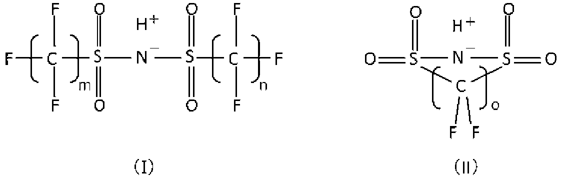 and salts thereof is preferable because it gives a conductive polymer layer with especially excellent heat resistance. In the above formulae, m is an integer number of 1 to 8, preferably an integer number of 1 to 4, and especially preferably 2, n is an integer number of 1 to 8, preferably an integer number of 1 to 4, and especially preferably 2, and o is 2 or 3.

The monomer to compose the conductive polymer has no restrictions as long as it is a substituted thiophene, that is, a compound selected from a group consisting of 3,4-disubstituted thiophenes. Substituents at the 3- and 4-positions of the thiophene ring can form a ring with carbons at the 3- and 4-positions. Especially, it is preferable if the monomer is EDOT because a conductive polymer layer with excellent environmental stability and catalytic activities to convert an oxidized species in an electrolyte layer into a reduced species can be obtained.

In the conductive polymer layer comprising a polymer derived from a monomer selected from substituted thiophenes and the dopant within the specific range above mentioned, there is a tendency that reduction quantities to convert an oxidized species in an electrolyte into a reduced species increases while the speed of reduction reaction decreases as the conductive polymer layer grows thicker. Therefore, in order to obtain a dye-sensitized solar cell that rapidly generates electricity by combining a positive electrode with this conductive polymer layer and a negative electrode with rapid photoelectron transfer reaction, it is preferable to set the thickness of the conductive polymer layer within the range of 1 to 2000 nm, preferably 35 to 350 nm, and especially preferably 70 to 350 nm (see W2012/133858A1 or WO2012/133859A1). However, when the inventors further considered the composition of a dye-sensitized solar cell, it was found that a satisfactory reduction reaction speed could be obtained for a dye-sensitized solar cell even with a thick conductive polymer layer. Further, it was found that the fill factor value of the dye-sensitized solar cell increases if the conductive polymer layer is made thick. Moreover, by setting the thickness of the conductive polymer as 100 nm or more, a battery with a higher fill factor value than a dye-sensitized solar cell having a positive electrode with a conventional Pt catalyst layer was obtained. This is considered to result from a high reduction catalytic activity and a high specific surface area of the conductive polymer layer in the present invention, and therefore, the dye-sensitized solar cell of the present invention is considered to have a high fill factor irrespective of the kind of semiconductor layer in the negative electrode.

The thickness of the conductive polymer to obtain a dye-sensitized solar cell that exhibits a high fill factor is within the range of 100 to 10000 nm, and preferably, 100 to 4200 nm. If the thickness of the conductive polymer is more than 10000 nm, the reduction reaction speed becomes insufficient because the internal resistance becomes high, and this is economically disadvantageous because electrolytic polymerization takes a long time.

The density of the conductive polymer layer is preferably within the range of 1.15 to 1.80 g/cm³, more preferably 1.20 to 1.80 g/cm³, and especially preferably 1.60 to 1.80 g/cm³. If the density is less than 1.15 g/cm³, thermal resistance rapidly decreases, and the manufacture of a conductive polymer layer with a density of more than 1.80 g/ cm³ is difficult. Moreover, to obtain a positive electrode with flexibility, it is preferable to set the density of the conductive polymer layer as 1.75 g/cm³ or less, and especially preferably as 1.70 g/cm³ or less because the conductive polymer layer becomes harder and less flexible if the density of the conductive polymer layer is too high.

The conductive polymer layer with a density within the range of 1.15 to 1.80 g/cm³ can be obtained by electrolytic polymerization using a polymerization solution comprising a solvent consisting of 80 to 100 % by mass of water and 0 to 20 % by mass of an organic solvent, a substituted thiophene as a monomer, and an organic non-sulfonate compound within the above-mentioned specific range. Since the organic non-sulfonate compound within the specific range acts as a supporting electrolyte in the polymerization solution, it is also referred to as an "organic non-sulfonate supporting electrolyte". The solvent consisting of 100 to 80 % by mass of water and 0 to 20 % by mass of an organic solvent is hereinafter referred to as a "water-rich solvent". In the water-rich solvent, the total amount of water and an organic solvent is 100 % by mass. If the contained amount of the organic solvent in the water-rich solvent increases, a conductive polymer film in which polymer particles are densely filled becomes difficult to be formed on an substrate by electrolytic polymerization, and if the amount of the organic solvent exceeds 20 % by mass of the whole solvent, the heat resistance of the conductive polymer layer obtained is remarkably lowered (see WO2012/133858A1 and WO2012/133859A1).

The semiconductor layer in the negative electrode can be formed with any materials that are used for a semiconductor layer in a conventional dye-sensitized solar cell, but it is preferable that titanium oxide, which has high photoelectric conversion efficiency, is used. There is no strict limitation in terms of the thickness of the semiconductor layer, but generally it should be within the range of 1 to 100 µm, preferably 3 to 50 µm, and particularly preferably 3 to 20 µm. If the thickness of the semiconductor layer is less than 1 µm, the light absorption can be insufficient, and the thickness of the semiconductor layer is more than 100 µm, it is not preferable because the travel distance of the electron from the oxide semiconductor to the conductive part of the substrate becomes long and the electron becomes deactivated.

### 3. Advantageous effects of the invention

The conductive polymer layer within the specific range, which is used as the catalyst layer of the positive electrode in the dye-sensitized solar cell of the present invention, has excellent catalytic activity to convert the oxidized species in the electrolyte layer into the reduced species and has excellent heat resistance. Moreover, the dye-sensitized solar cell of the present invention having the positive electrode with the conductive polymer layer within the specific range is less expensive, is prepared by an easier manufacturing method, and has higher photoelectric conversion efficiency due to a higher fill factor value, compared with a dye-sensitized solar cell using a positive electrode with a conventional Pt catalyst layer.

### BRIEF DESCRIPTION OF THE DRAWINGS

Figure 1 shows a cyclic voltammogram in an electrolyte containing an I⁻/I₃⁻ redox pair of a positive electrode having a PEDOT layer obtained by electrolytic polymerization using a polymerization solution containing ammonium borodisalicylate and EDOT.
Figure 2 shows a cyclic voltammogram in an electrolyte containing an I⁻/I₃⁻ redox pair of a positive electrode having a PEDOT layer obtained by electrolytic polymerization using a polymerization solution containing sodium bis(trifluoromethanesulfonyl)imide and EDOT.
Figure 3 shows a cyclic voltammogram in an electrolyte containing an I⁻/I₃⁻ redox pair of a positive electrode having a PEDOT layer obtained by electrolytic polymerization using a polymerization solution containing ammonium bis(nonafluorobutanesulfonyl)imide and EDOT.
Figure 4 shows a cyclic voltammogram in an electrolyte containing an I⁻/I₃⁻ redox pair of a positive electrode having a PEDOT layer obtained by electrolytic polymerization using a polymerization solution containing ammonium 1,1,2,2,3,3-hexafluoro-1,3-disulfonylimide and EDOT.
Figure 5 shows a cyclic voltammogram of an electrolyte containing an I⁻/I₃⁻ redox pair of a positive electrode having a PEDOT layer obtained from a slurry containing PEDOT:PSS.
Figure 6 shows a cyclic voltammogram in an electrolyte containing an I⁻/I₃⁻ redox pair of a positive electrode having a PEDOT layer obtained by chemical polymerization of EDOT using iron(III) tris(p-toluenesulfonate) as an oxidizing agent.
Figure 7 shows the relationship between the thickness of a PEDOT layer and the value of short-circuit current density on dye-sensitized solar cells with a positive electrode having a PEDOT layer with different thickness.
Figure 8 shows the relationship between the thickness of a PEDOT layer and the value of open voltage on dye-sensitized solar cells with a positive electrode having a PEDOT layer with different thickness.
Figure 9 shows the relationship between the thickness of a PEDOT layer and the value of fill factor on dye-sensitized solar cells with a positive electrode having a PEDOT layer with different thickness.
Figure 10 shows the relationship between the thickness of a PEDOT layer and the value of photoelectric conversion efficiency on dye-sensitized solar cells with a positive electrode having a PEDOT layer with different thickness.
Figure 11 shows the relationship between the thickness of a titanium oxide porous layer and the value of fill factor on dye-sensitized solar cells with a negative electrode having a titanium oxide porous layer with different thickness.
Figure 12 shows the relationship between the charge transport impedance of I⁻/I₃⁻ oxidation-reduction reaction and the thickness of a PEDOT layer on dye-sensitized solar cells with a positive electrode having a PEDOT layer with different thickness.
Figure 13 shows the relationship between the reduction charge calculated from the cyclic voltammogram in an electrolyte containing an I⁻/I₃⁻ redox pair and the thickness of a PEDOT layer on positive electrodes having a PEDOT layer with different thickness.
Figure 14 shows the relationship between the thickness of a PEDOT layer and the value of short-circuit current density on dye-sensitized solar cells with a negative electrode having an even titanium oxide porous layer.
Figure 15 shows the relationship between the thickness of a PEDOT layer and the value of open voltage on dye-sensitized solar cells with a negative electrode having an even titanium oxide porous layer.
Figure 16 shows the relationship between the thickness of a PEDOT layer and the value of fill factor on dye-sensitized solar cells with a negative electrode having an even titanium oxide porous layer.
Figure 17 shows the relationship between the thickness of a PEDOT layer and the value of photoelectric conversion efficiency on dye-sensitized solar cells with a negative electrode having an even titanium oxide porous layer.

### DETAILED DESCRIPTION OF THE INVENTION

An explanation of a positive electrode having a conductive polymer layer within the above-mentioned specific range will be given first, and then, an explanation of the whole dye-sensitized solar cell will be given.

### A: Positive electrode

A positive electrode for a dye-sensitized solar cell of the present invention has a conductive polymer layer that contains a polymer derived from at least one kind of monomer selected from substituted thiophenes and an anion as a dopant to the polymer generated from at least one kind of organic non-sulfonate compound having an anion with the molecular weight of 200 or more and has a thickness within the range of 100 to 10000 nm. This conductive polymer layer can be prepared by a method that comprises a preparation process to obtain a polymerization solution for electrolytic polymerization containing the monomer and the organic non-sulfonate compound and a polymerization process to introduce a substrate with a conductive part into the polymerization solution obtained and perform electrolytic polymerization so that a conductive polymer layer obtained by the polymerization of the monomers is formed on the conductive part of the substrate. Detailed explanations of each process are hereinafter given.

### (1) Preparation process

A polymerization solution for electrolytic polymerization prepared in this process comprises, as essential ingredients, a water-rich solvent, a substituted thiophene as a monomer, and an organic non-sulfonate compound within the specific range above mentioned.

In the preparation of the polymerization solution, water, which has a small environmental impact and is economically advantageous, is used as the main solvent. Organic solvents such as methanol, ethanol, isopropanol, butanol, ethylene glycol, acetonitrile, acetone, tetrahydrofuran, and methyl acetate may be contained in the polymerization solution, but 80 % by mass or more of the total solvent is water. Water is preferably 90 % by mass or more of the total, more preferably 95 % by mass or more of the total, and it is especially preferred that the solvent consists of water only. When the amount of the organic solvent contained in the water-rich solvent is increased, it is difficult for a conductive polymer film in which polymer particles are densely filled to form on the substrate by electrolytic polymerization, and if the amount of the organic solvent exceeds 20 % by mass of the whole solvent, the heat resistance of the conductive polymer layer obtained is remarkably lowered.

As a monomer, a substituted thiophene, that is, a monomer selected from 3,4-disubstituted thiophenes, is used. In substituents at position 3 and position 4 of a thiophene ring, a ring can be formed together with carbons at position 3 and position 4. Examples of monomers that can be used are: 3,4-dialkylthiophenes such as 3,4-dimethylthiophene and 3,4-diethylthiophene; 3,4-dialkoxythiophenes such as 3,4-dimethoxythiophene and 3,4-diethoxythiophene; 3,4-alkylenedioxythiophenes such as 3,4-methylenedioxythiophene, EDOT and 3,4-(1,2-propylenedioxy)thiophene; 3,4-alkyleneoxythiathiophenes such as 3,4-methyleneoxythiathiophene, 3,4-ethyleneoxythiathiophene and 3,4-(1,2-propyleneoxythia)thiophene; 3,4-alkylenedithiathiophenes such as 3,4-methylenedithiathiophene, 3,4-ethylenedithiathiophene and 3,4-(1,2-propylenedithia)thiophene; and alkylthieno[3,4-b]thiophenes such as thieno[3,4-b]thiophene, isopropylthieno[3,4-b]thiophene and t-butyl-thieno[3,4-b]thiophene. For the monomer, a single compound can be used, or two or more types can be mixed and used. In particular, the usage of EDOT is preferred.

For a supporting electrolyte in the polymerization solution, an organic non-sulfonate compound having an anion with a molecular weight of 200 or more is used. The anion of the supporting electrolyte is contained in a conductive polymer film as a dopant during the following electrolytic polymerization process. Especially, borodisalicylic acid, borodisalicylic salts, a sulfonylimidic acid of the formula (I) or the formula (II) 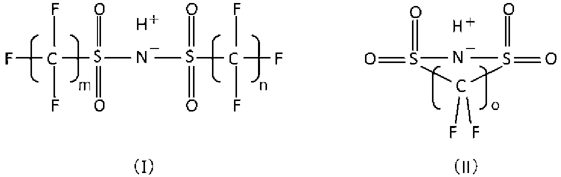 where m is an integer from 1 to 8, preferably an integer from 1 to 4, especially preferably 2, n is an integer from 1 to 8, preferably an integer from 1 to 4, especially preferably 2, and o is 2 or 3, and salts thereof, are preferably used. For salts, alkali metal salts such as lithium salt, sodium salt and potassium salt; ammonium salt; alkylammonium salts such as ethylammonium salt and butylammonium salt; dialkylammonium salts such as diethylammonium salt and dibutylammonium salt; trialkylammonium salts such as triethylammonium salt and tributylammonium salt; and tetraalkylammonium salts such as tetraethylammonium salt and tetrabutylammonium salt can be exemplified. These supporting electrolytes give conductive polymers with outstanding heat resistance. Among them, salts of bis(pentafluoroethanesulfonyl)imide acid, for examples potassium salt, sodium salt, and ammonium salt give a conductive polymer layer with an extremely high heat resistance.

Borodisalicylic acid and a borodisalicylic salt are preferable because they are inexpensive and economically advantageous, and give a conductive polymer layer with excellent heat resistance, but it is found that a borodisalicylate ion contained in the borodisalicylic acid and the borodisalicylic salt is hydrolyzed in water into salicylic acid and boric acid, which have remarkably low solubility in water. Therefore, if the borodisalicylic acid and/or the borodisalicylic salt are used as a supporting electrolyte, precipitation is gradually produced in a polymerization solution and the polymerization solution becomes unusable. In order to avoid this, if borodisalicylic acid and/or a borodisalicylic salt are used as a supporting electrolyte, electrolytic polymerization is performed after this supporting electrolyte is added to the solution and before precipitate is formed, or a stabilizer selected from a group consisting of nitrobenzene and a nitrobenzene derivative, which inhibits hydrolysis of the borodisalicylate ion, is used together with borodisalicylic acid and/or its salt. The stabilizer can be a single compound or two or more types of compounds. Examples of nitrobenzene derivatives are: nitrophenol, nitrobenzyl alcohol, nitrobenzoic acid, dinitrobenzoic acid, dinitrobenzene, nitroanisole and nitroacetophenone. O-nitrophenol, m-nitrophenol, p-nitrophenol, or a mixture of these is preferred.

The supporting electrolyte can be a single compound or two or more types of compounds, which is used in a concentration of the saturated amount of dissolution or less in the polymerization solution and at an amount with which a sufficient electric current for polymerization can be obtained. The supporting electrolyte is used preferably in a concentration of 10 mM or more, and especially preferably, 30 mM or more.

Preparation of the polymerization solution is performed by the following methods according to the contained amount of the monomer. When the amount of the monomer is a saturated amount of dissolution or less, a polymerization solution is prepared by introducing into a container for manufacturing a polymerization solution the water-rich solvent, the substituted thiophene as the monomer, and the supporting electrolyte of the specific range, and by dissolving each component to the water-rich solvent by hand process or by use of a mechanical stirring means. When the amount of the monomer exceeds a saturated amount of dissolution, that is, when the monomer undergoes phase separation by introducing into a container for manufacturing a polymerization solution the water-rich solvent, the substituted thiophene as the monomer, and the supporting electrolyte of the specific range and by standing still after stirring and homogenization, the polymerization solution can be prepared by dispersing the phase-separated monomer as oil drops in the polymerization solution by giving ultrasonic wave irradiation to the solution. The polymerization solution in the present invention can also be obtained by dispersing the monomer as oil drops with ultrasonic wave irradiation to a solution in which the monomer at an amount exceeding the saturated amount of dissolution is added to the water-rich solvent, and by adding the supporting electrolyte to the solution obtained. If each of the components in the polymerization solution is stable, there is no restriction on the temperature at the time of preparation. In this description, an "ultrasonic wave" is a sound wave with frequency of 10 kHz or more.

For ultrasonic wave irradiation, an ultrasonic oscillator which is heretofore been known, such as one for an ultrasonic washing machine or a cell crusher, can be used without any restriction. In order to obtain by ultrasonic wave irradiation a solution in which monomer oil drops are stably dispersed in the water-rich solvent, it is necessary to change the phase-separated monomer to oil drops of a diameter of several µm or less. To achieve this, it is necessary to irradiate the phase-separated solution with ultrasonic wave having a frequency of 15 to 200 kHz, which can generate a cavitation of at least several hundreds of nm to several µm with a strong mechanical action. It is preferable that the output of ultrasonic wave is 4 or more w/cm². Although there is no strict limitation on the time of the ultrasonic wave irradiation, it is preferably within a range of 2 to 10 minutes. If the irradiation time is longer, there is a tendency that aggregation of the monomer oil drops is inhibited and that the time for demulsification is longer, but when the time of the ultrasonic wave irradiation is 10 minutes or more, a tendency that the effect of inhibiting aggregation of the oil drops is saturated. It is also possible to perform more than one irradiations by using ultrasonic waves with different frequencies and/or outputs. The contained amount of monomer exceeding the saturated amount of dissolution is appropriate as long as it is an amount to obtain a dispersion solution in which demulsification is inhibited by ultrasonic wave irradiation and varies according to not only the type of monomer, but also the type and amount of a supporting electrolyte and the condition of ultrasonic wave irradiation.

The polymerization solution in the present invention may contain other additives insofar as they do not give harmful influence on the present invention in addition to the water-rich solvent, the monomer selected from substituted thiophenes, and the supporting electrolyte within the above-mentioned specific range. A water-soluble nonionic surfactant can be referred to as a preferable additive. Because the monomer is condensed in a micelle of the nonionic surfactant, electrolytic polymerization progresses rapidly, and a polymer exhibiting high conductivity can be obtained. In addition, the nonionic surfactant itself is not ionized, and doping to a polymer by an anion of the supporting electrolyte within the specific range is not inhibited.

As the nonionic surfactant, a water-soluble nonionic surfactant heretofore known can be used without particular restriction. It is possible to use, for example, polyalkylene glycol, polyvinyl alcohol, polyoxyalkylene alkyl ether, polyoxyalkylene alkylphenyl ether, polyoxyalkylene styrylphenyl ether, polyoxyalkylene benzylphenyl ether, polyoxyalkylene alkylphenol ether formaldehyde condensate, polyoxyalkylene styrylphenol ether formaldehyde condensate, polyoxyalkylene benzylphenol ether formaldehyde condensate, alkynediol, polyoxyalkylene alkynediol ether, polyoxyalkylene fatty acid ester, polyoxyalkylene sorbitan fatty acid ester, polyoxyalkylene castor oil, polyoxyalkylene hardened castor oil, polyglycerol alkyl ether and polyglycerol fatty acid ester. These can be used alone or used by mixing two or more types. It is preferable to use in the polymerization solution a combination of an alkynediol having a high dispersion effect such as 2,4,7,9-tetramethyl-5-decyne-4,7-diol with other nonionic surfactants, preferably a polyoxyethylene alkylphenyl ether such as branched polyoxyethylene(9) nonylphenyl ether, because the contained amount of monomer in the polymerization solution can be increased to a great extent.

If the nonionic surfactant is used concurrently, a polymerization solution is prepared by introducing into a container for manufacturing a polymerization solution the water-rich solvent, the monomer, the supporting electrolyte within the specific range and the nonionic surfactant, and by dissolving each component into the water-rich solvent by hand processing or a mechanical stirring means or an ultrasonic wave radiation. Also, after introducing into a container for producing a polymerization solution the water-rich solvent, the monomer, and the nonionic surfactant and preparing a solution in which each component is dissolved in the water-rich solvent, dissolution can be made by adding the supporting electrolyte within the specific range to this solution immediately before electrolytic polymerization.

In any method to produce a polymerization solution, if borodisalicylic acid and/or a borodisalicylic salt as a supporting electrolyte and nitrobenzene and/or a nitrobenzene derivative as a stabilizer are used concurrently, both are almost simultaneously introduced in a container to manufacture polymerization solution or the stabilizer is introduced first. This is because the stabilizer is used to inhibit the hydrolysis of a borodisalicylate ion.

### (2) Polymerization process

By introducing a working electrode with a conductive part at least on the surface (a substrate of a conductive polymer layer) and a counter electrode into the polymerization solution obtained by the above-mentioned preparation process, and then performing electrolytic polymerization, a conductive polymer layer by polymerization of the substituted thiophene is formed on the conductive part of the working electrode and a positive electrode for a dye-sensitized solar cell is obtained.

The material, shape and size of a working electrode with a conductive part at least on the surface is selected according to usage. The conductive part of a substrate can be a single layer or include multiple different layers. For example, a plate or foil of conductive material such as platinum, gold, nickel, titanium, steel, rhodium and ruthenium can be used as the working electrode. However, since the conductive polymer layer obtained by this polymerization process has excellent transparency, it is preferable to use as the working electrode a transparent substrate in which a transparent layer of conductive material such as indium oxide, tin-doped indium oxide (ITO), zinc-doped indium oxide (IZO), tin oxide, antimony-doped tin oxide (ATO), fluorine-doped tin oxide (FTO), zinc oxide, and aluminum-doped zinc oxide (AZO) is formed by vapor deposition or coating on the surface of an insulating transparent substrate of glass such as optical glass, quartz glass, and alkali-free glass or plastic such as polyethylene terephthalate, polyethylene naphthalate, polycarbonate polyethersulfone, and polyacrylate. Moreover, a substrate in which a film of a metal such as platinum, nickel, titanium, rhodium and ruthenium is formed by vapor deposition or coating on the above-mentioned glass substrate or plastic substrate can be used as the working electrode.

As the counter electrode of electrolytic polymerization, a board of platinum, nickel or the like can be used.

Electrolytic polymerization is performed using the polymerization solution obtained in the preparation process by any of a potentiostatic method, a galvanostatic method or a potential sweep method. In the case of the potentiostatic method, a potential of 1.0 to 1.5 V for a saturated calomel electrode is preferable though this depends on the type of monomer; and in the case of the galvanostatic method, a current value of 1 to 10000 µA/cm², preferably 5 to 500µA/cm², more preferably 10 to 100 µA/cM² is preferable though this depends on the type of monomer; and in the case of the potential sweep method, it is preferable to sweep a range of -0.5 to 1.5 V for a saturated calomel electrode at a velocity of 5 to 200 mV/s though this depends on the type of monomer. A polymerization temperature has no strict limitation, but is generally within a range of 10 to 60 degrees centigrade. A polymerization time changes according to the composition of a polymerization solution and the conditions of electrolytic polymerization, but it is generally within a range of 0.6 seconds to 2 hours, preferably 1 to 10 minutes, and especially preferably 2 to 6 minutes.

By electrolytic polymerization, a conductive polymer layer, in which an anion of the organic non-sulfonate supporting electrolyte within the specific range mentioned above is included as a dopant, is formed on the conductive part of the working electrode. The density of the conductive polymer layer obtained is within the range of 1.15 to 1.80 g/cm³. If the density of the conductive polymer layer is less than 1.15 g/cm³, heat resistance rapidly decrease, and the manufacture of a conductive polymer layer with a density of more than 1.80 g/cm³ is difficult. The density of the conductive polymer layer with excellent heat resistance is preferably within the range of 1.20 to 1.80 g/cm³, and especially preferably within the range of 1.60 to 1.80 g/cm³. When a flexible positive electrode is to be obtained, since a conductive polymer layer becomes hard and less flexible if the density of the conductive polymer is too high, the density of the conductive polymer is preferably 1.75 g/cm³ or less, and more preferably 1.70 g/cm³ or less.

The thickness of the conductive polymer layer is generally within the range of 100 to 10000 nm, preferably 100 to 4200 nm. If the thickness of the conductive polymer layer is 10000 nm or more, the internal resistance becomes high and the speed of reduction reaction to convert an oxidized species in an electrolyte to a reduced species becomes insufficient, and it is economically disadvantageous because electrolytic polymerization requires a long time. Also, if the thickness of the conductive polymer exceeds 4200 nm, a crack may be found in the conductive polymer layer. Therefore, it is preferable that the thickness of the conductive polymer is 4200 nm or less. The thickness of the conductive polymer layer can be measured by an atomic force microscope etc. Also, after galvanostatic electrolytic polymerization is performed more than one time at a given current density for different time durations, the thickness of the conductive polymer layer obtained by each galvanostatic electrolytic polymerization is measured, and the calculating equation to show the relationship between the thickness obtained and the conducted electric charge in the electrolytic polymerization is derived, and the thickness of a conductive polymer layer can be calculated based on the conducted electric charge with the derived calculating equation.

By cleaning the conductive polymer layer after electrolytic polymerization with water, ethanol or the like, and drying it, a positive electrode in which a conductive polymer layer with excellent heat resistance is formed with good adhesion on a substrate can be obtained. The conductive polymer layer in the positive electrode is air-moisture stable, and there is no danger that other components will be eroded in the process of manufacture or usage of the solar cell because the conductive polymer layer has the pH value close to a neutral value.

### B: Dye-sensitized solar cell

A dye-sensitized solar cell has a negative electrode with a semiconductor layer containing a pigment as a photosensitizer, an electrolyte layer located on the semiconductor layer of the negative electrode containing a paired oxidized species and reduced species, and the above-mentioned positive electrode. The conductive polymer layer of the above-mentioned positive electrode has sufficient catalytic activity to convert an oxidized species constituting a redox pair into a reduced species in the electrolyte layer.

For a conductive substrate and a semiconductor layer composing a negative electrode in a dye-sensitized solar cell, a conductive substrate and a semiconductor layer in a conventional dye-sensitized solar cell can be used without particular restriction.

As the conductive substrate, a substrate with a conductive part at least on the surface can be used, and the conductive part of the substrate may be a single layer or may contain different kinds of multilayer. For example, a plate or a foil of conductive material such as platinum, nickel, titanium, steel, chromium, niobium, molybdenum, ruthenium, rhodium, tantalum, tungsten, iridium and hastelloy can be used as the substrate, or, a transparent substrate in which a transparent conductive layer such as indium oxide, ITO, IZO, tin oxide, ATO, FTO, zinc oxide, AZO layer is formed by vapor deposition or coating on the surface of an insulating transparent substrate of glass such as optical glass, quartz glass and alkali-free glass, or plastic such as polyethylene terephthalate, polyethylene naphthalate, polycarbonate polyethersulfone and polyacrylate, can be also used. Moreover, a substrate in which a metallic film such as platinum, nickel, titanium, rhodium and ruthenium film is formed by vapor deposition or coating on the above-mentioned glass substrate or plastic substrate can be used. In case a substrate contained in the positive electrode is opaque, a transparent substrate is used as a substrate in the negative electrode. Moreover, if the substrate contained in the positive electrode is transparent, a fully-transparent solar cell can be composed by using a transparent substrate also for the negative electrode.

The semiconductor layer can be formed by using an oxide semiconductor such as titanium oxide, zirconium oxide, zinc oxide, tin oxide, nickel oxide, niobium oxide, magnesium oxide, tungstic oxide, bismuth oxide, indium oxide, thallium oxide, lanthanum oxide, yttrium oxide, phosphonium oxide, cerium oxide, aluminum oxide, cadmium sulfide, cadmium selenide, cadmium telluride, calcium titanate, strontium titanate and barium titanate. As the oxide semiconductor, a single compound can be used, or two or more types can be mixed and used. It is preferable that titanium oxide, which has high photoelectric conversion efficiency, is used. The oxide semiconductor is generally used in a porous embodiment so that many pigments can be supported in the semiconductor layer.

As the pigment that acts as a photosensitizer, an organic dye or a metal complex dye that has absorption in the visible light region and/or the infrared light range can be used. As an organic dye, pigments such as coumalins, cyanines, merocyanines, phthalocyanines, porphyrins, azos, quinones, quinone imines, quinacridones, squaryliums, triphenylmethanes, xanthenes, perylenes, indigos and naphthalocyanines can be used, and it is preferable to use a coumalin pigment. As a metal complex dye, osmium complexes, ruthenium complexes, iron complexes, zinc complexes, platinum complexes, or palladium complexes can be used, and especially, it is preferable to use a ruthenium bipyridine complex such as N3 and N719 or a ruthenium terpyridine complex such as N749 and a ruthenium quaterpyridine complex in that they have a wide absorption band. Moreover, it is preferable to use a pigment with an interlocking group such as carboxyl group, alkoxy group, hydroxyl group, hydroxyalkyl group, sulfonic acid group, ester group, mercapto group, phosphonyl group in a pigment molecule for a pigment to be absorbed firmly in a porous semiconductor oxide layer and to facilitate electron transfer between the pigment in an excited state and the conduction band of a porous semiconductor oxide layer. Among them, it is especially preferable to use one with a carboxyl group. Also, if a part of an acidic functional group such as carboxyl group is anionized by neutralization with a compound such as alkali metal hydroxide, tetraalkylammonium hydroxide, imidazolium hydroxide and pyridinium hydroxide, association between pigment molecules are inhibited by a repulsive force among anions, and significant reduction of an electron trap between dye molecules can be realized. For these pigments, a single compound can be used, or a mixture of two or more types can also be used.

The negative electrode of the dye-sensitized solar cell can be obtained by a heretofore known method. For example, the porous layer of an oxide semiconductor is formed on a substrate by applying on the substrate a dispersion containing oxide semiconductor particles above mentioned and an organic binder such as polytetrafluoroethylene, polyvinylidene fluoride and carboxymethylcellulose by a wet process such as spin coat, bar coat or cast coating, drying the dispersion by heating, and then firing at a temperature of 400 to 500 degrees centigrade. As an oxide semiconductor particle, a particle in a spherical shape, rod-shape, or needle shape with an average primary particle of 1 to 200 nm is preferably used. It is preferable if the process of application of the dispersion as well as drying by heating is repeated more than once and thereafter firing at a temperature of 400 to 500 degrees centigrade is performed, so that an even, thick, porous layer can be obtained. By this layer, the short-circuit current density of the dye-sensitized solar cell can be improved and thus the photoelectric conversion efficiency can also be improved. Moreover, to improve the necking among oxide semiconductor particles, electron transportation characteristics and photoelectric conversion efficiency, it is also acceptable that a TiCl4 solution is osmosed in the porous layer of an oxide semiconductor, its surface is washed with water, and then it is burned at a temperature of 400 to 500 degrees centigrade. Then, the substrate after firing is immersed in a solution in which the above-mentioned pigment is dissolved into a solvent such as ethanol, isopropyl alcohol and butyl alcohol, is taken out from the immersion solution after the predetermined time is elapsed, is dried and the pigment is supported in the oxide semiconductor, so that a negative electrode can be obtained. It is preferable that, after the pigment is supported in the oxide semiconductor, the substrate obtained is immersed in a solution containing an inhibitor of reverse electron transfer with a functional group that combines with a semiconductor including imidazolyl group, carboxy group and phosphonate group, for example, tert-butylpyridine, 1-methoxybenzimidazole and a phosphonic acid with a long-chain alkyl group (the carbon number: approximately 13) such as decane phosphoric acid. Reverse electron transfer in the electrolyte is prevented and elution of the pigment becomes difficult into the electrolyte, because the inhibitor of reverse electron transfer is adsorbed in the interspace between the pigments on the semiconductor surface. The thickness of the semiconductor layer is generally within the range of 1 to 100 µm, preferably 3 to 50 µm, particularly preferably 3 to 20 µm. If the thickness of the semiconductor layer is less than 1 µm, the light absorption can be insufficient, and the thickness of the semiconductor layer is more than 100 µm, it is not preferable because the travel distance of the electron from the oxide semiconductor to the conductive part of the substrate becomes long and the electron becomes deactivated.

As the electrolyte to compose the electrolyte layer of the dye-sensitized solar cell, an electrolyte in which a redox pair such as a combination of metal or organic iodide and iodine constituting an iodine redox pair, a combination of a metal or organic bromide and bromine constituting a bromine redox pair, or a Co(II) polypyridine complex constituting a cobalt complex redox pair is dissolved into an organic solvent such as acetonitrile, methoxyacetonitrile, 3-methoxypropionitrile, propylene carbonate, ethylene carbonate, γ-butyrolactone and ethylene glycol can be used. In addition, as a redox pair, a metal complex such as ferrocyanide / ferricyanide and ferrocene / ferricinium ion, a sulfur compound such as sodium polysulfide and alkylthiol / alkyl disulfide, viologen dye, and hydroquinone / quinone can be used. As a cation of the metallic compound, Li, Na, K, Mg, Ca and Cs are preferable, and as a cation of the organic compound, tetraalkylammoniums, pyridiniums and imidazoliums are preferable. Among them, it is preferable to use the combination of iodide and iodine, which has high photoelectric conversion efficiency, and especially, it is preferable to use the combination of I₂ and an alkali metal iodide including Lil, Nal and KI, an imidazolium compound such as dimethylpropyl imidazolium iodide or a quaternary ammonium iodide. The concentration of the salt in the organic solvent is preferably 0.05 to 5 M, more preferably 0.2 to 2 M. The concentration of I₂ and Br₂ is preferably 0.0005 to 1 M, more preferably 0.001 to 0.2 M. Moreover, various additives such as 4-tert-butylpyridine and carboxylic acid can be added to improve the open voltage of a dye-sensitized solar cell. Further, a supporting electrolyte such as lithium iodide and lithium tetrafluoroborate may be added if necessary to the electrolyte.

The electrolyte layer can be formed by gel electrolyte in which the electrolyte becomes pseudo-solid with addition of gelatinizer. If it is made a physical gel, polyacrylonitrile, and polyvinylidene fluoride can be used as gelatinizer, and if it is made a chemical gel, acryl(methacryl)ester oligomer and a combination of tetra(bromomethyl)benzene and polyvinylpyridine can be used as gelatinizer.

The dye-sensitized solar cell can be obtained by a heretofore known method by using the above-mentioned positive electrode. For example, the cell can be obtained by placing the semiconductor layer of the negative electrode and the conductive polymer layer of the positive electrode at a given interval, injecting electrolyte in the interval, and heating if necessary to form an electrolyte layer. The thickness of the electrolyte layer is, except for the thickness of the electrolyte layer osmosed in the semiconductor layer, generally within the range of 1 to 100 µm, preferably within the range of 1 to 50 µm. If the thickness of the electrolyte layer is less than 1 µm, the semiconductor layer of the negative electrode may short-circuit, and if the thickness of the electrolyte layer is more than 100 µm, it is not preferable because the internal resistance becomes high.

### EXAMPLES

The examples of the present invention are shown as follows, but the present invention is not limited to the following examples.

Heat resistance of a positive electrode used for a dye-sensitized solar cell of the present invention is described first and then the dye-sensitized solar cell of the present invention is described. Thickness of a conductive polymer of the positive electrode was calculated as follows. First, galvanostatic electropolymerization was performed for 1 minute under the condition of 0.1 mA/cm² on an ITO electrode to form a conductive polymer layer and then an experiment to measure the thickness of the polymer layers with an atomic force microscope was performed. Next, galvanostatic electropolymerization was carried out for 28.6 minutes under the condition of 0.1 mA/cm² on an ITO electrode to form a conductive polymer layer and then an experiment was performed to evaluate the thickness of the polymer layer with a step gauge. Based on the two experiments, the relational expression between the charge amount and the thickness of the conductive polymer layer was calculated. Then, by using the relational expression, the charge amount of electrolytic polymerization was converted to the thickness of the conductive polymer layer.

### (1) Evaluation of heat resistance of a positive electrode

### (a) Manufacture of a positive electrode

### Positive electrode A

A polymerization solution in which the total amount of EDOT was dissolved was obtained by introducing 50 mL of distilled water into a glass container, adding to this solution p-nitrophenol at the concentration of 0.10 M, EDOT at the concentration of 0.0148 M, and ammonium borodisalicylate at the concentration of 0.08 M in this order, and stirring it. An FTO electrode as a working electrode with an area of 1 cm² (surface resistance of the FTO layer: 10Ω/□ and a SUS mesh as a counter electrode with an area of 5 cm² were introduced to the obtained polymerization solution, and galvanostatic electrolytic polymerization was performed for 10 minutes under a current condition of 100 µA/cm². The working electrode after electrolytic polymerization was washed with methanol and then dried at 160 degrees centigrade for 30 minutes, and a positive electrode in which a PEDOT layer (dopant: borodisalicylate anion) with the thickness of 350 nm was formed on the FTO electrode was obtained. The density of the PEDOT layer was approximately 1.6 g/cm³.

### Positive electrode B

A polymerization solution in which the total amount of EDOT was dissolved was obtained by introducing 50 mL of distilled water into a glass container, adding to this solution EDOT at the concentration of 0.0148 M and sodium bis(trifluoromethanesulfonyl)imide at the concentration of 0.08 M and stirring it. An FTO electrode as a working electrode with an area of 1 cm² (surface resistance of the FTO layer: 10Ω/□ and a SUS mesh as a counter electrode with an area of 5 cm² were introduced to the obtained polymerization solution, and galvanostatic electrolytic polymerization was performed for 10 minutes under a current condition of 100 µA/cm². The working electrode after electrolytic polymerization was washed with methanol and then dried at 160 degrees centigrade for 30 minutes, and a positive electrode in which a PEDOT layer (dopant: bis(trifluoromethanesulfonyl)imide anion) with the thickness of 350 nm was formed on the FTO electrode was obtained. The density of the PEDOT layer was approximately 1.6 g/cm³.

### Positive electrode C

The manufacturing procedure for positive electrode B was repeated by using ammonium bis(nonafluorobutanesulfonyl)imide at the concentration of 0.08 M instead of sodium bis(trifluoromethanesulfonyl)imide at the concentration of 0.08 M, and a positive electrode in which a PEDOT layer (dopant: bis(nonafluorobutanesulfonyl)imide anion) at the thickness of 350 nm was formed on the FTO electrode was obtained. The density of the PEDOT layer was approximately 1.6 g/cm³.

### Positive electrode D

The manufacturing procedure for positive electrode B was repeated by using ammonium 1,1,2,2,3,3-hexafluoro-1,3-disulfonylimide at the concentration of 0.08 M instead of sodium bis(trifluoromethanesulfonyl)imide at the concentration of 0.08 M, and a positive electrode in which a PEDOT layer (dopant: 1,1,2,2,3,3-hexafluoro-1,3-disulfonylimide anion) was formed on the FTO electrode was obtained. The density of the PEDOT layer was approximately 1.6 g/cm³.

### Positive electrode E (not forming part of the invention)

100 µL of commercially available aqueous PEDOT:PSS dispersion (trade name: Baytron P, manufactured by H. C. Starck) was cast on an FTO electrode with an area of 1 cm² (surface resistance of the FTO layer: 10Ω/□ and spin coating was carried out for 30 seconds at the rotation frequency of 5000 rpm. Then, it was dried at 160 degrees centigrade for 30 minutes and a positive electrode with a PEDOT:PSS layer as described in Non-Patent Document 1 was obtained.

### Positive electrode F (not forming part of the invention)

100 µL of reaction solution in which EDOT (0.48 M), iron(III) tris(p-toluenesulfonate), and dimethylsulfoxide were dissolved into n-butanol at the mass ratio of 1:8:1 was cast on an FTO electrode with an area of 1 cm² (surface resistance of the FTO layer: 10Ω/□ and spin coating was carried out for 30 seconds at the rotation frequency of 2000 rpm. After chemical polymerization was progressed by heating the FTO electrode with this reaction solution at 110 degrees centigrade for 5 minutes, the FTO electrode was washed with methanol and dried at 160 degrees centigrade for 30 minutes, and a positive electrode with a chemical polymerization layer of PEDOT which contains p-toluenesulfonate anion as a dopant as described in Patent Document 1 was obtained.

### (b) Evaluation of electrochemical response in I⁻/I₃⁻ electrolyte

For the positive electrodes A to F, electrochemical response in I⁻/I₃⁻ electrolyte was evaluated by cyclic voltammograms.

A positive electrode of any one of the positive electrodes A to F, a platinum mesh as a counter electrode with an area of 4 cm², and a silver-silver chloride electrode as a reference electrode were introduced in an electrolyte in which 10 mM lithium iodide, 1 mM iodine, and 1 M lithium tetrafluoroborate were dissolved in acetonitrile, and the cyclic voltammogram was evaluated with a scanning potential range of -0.8 to +0.8 V, with a scanning rate of 10 mV/s.

Then, the positive electrodes A to F were taken out of the electrolyte, and after washing, thermal aging in high-temperature atmosphere was carried out for 500 hours at 160 degrees centigrade in air, and cyclic voltammograms were obtained again.

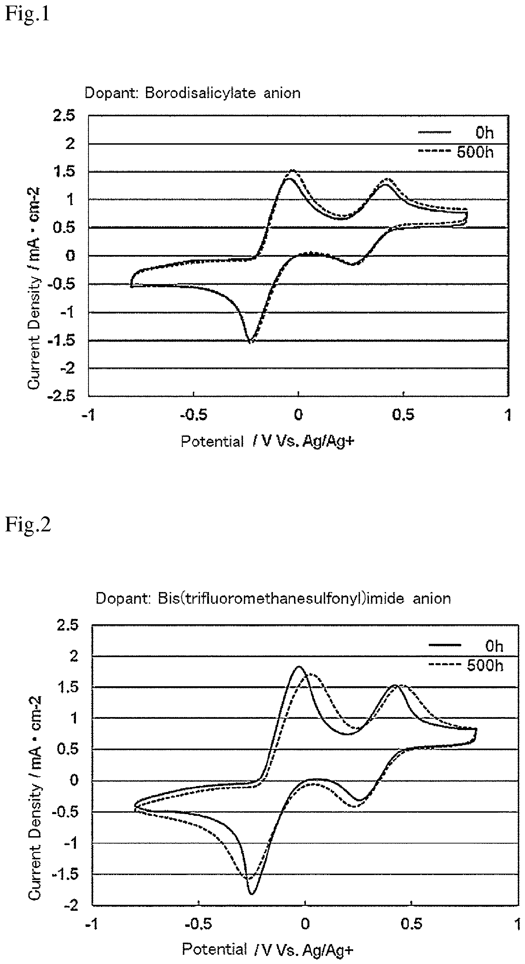

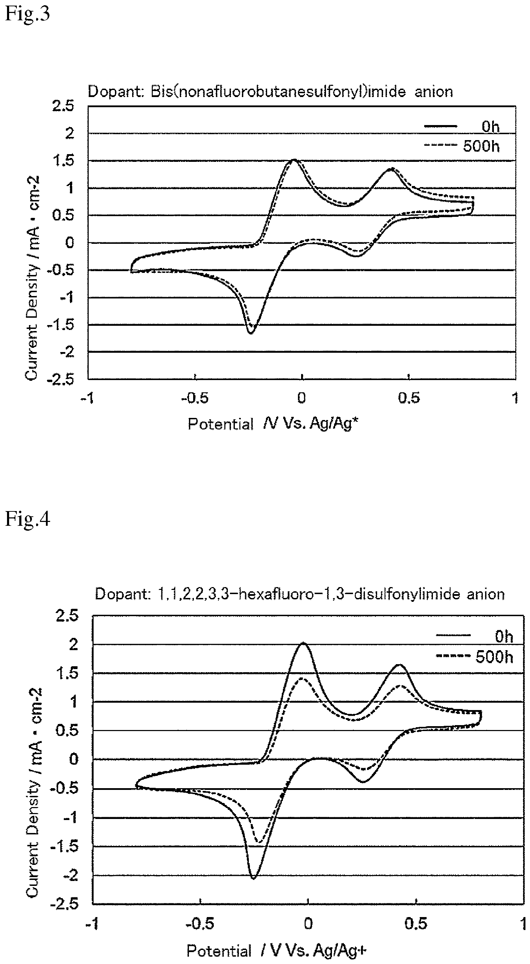

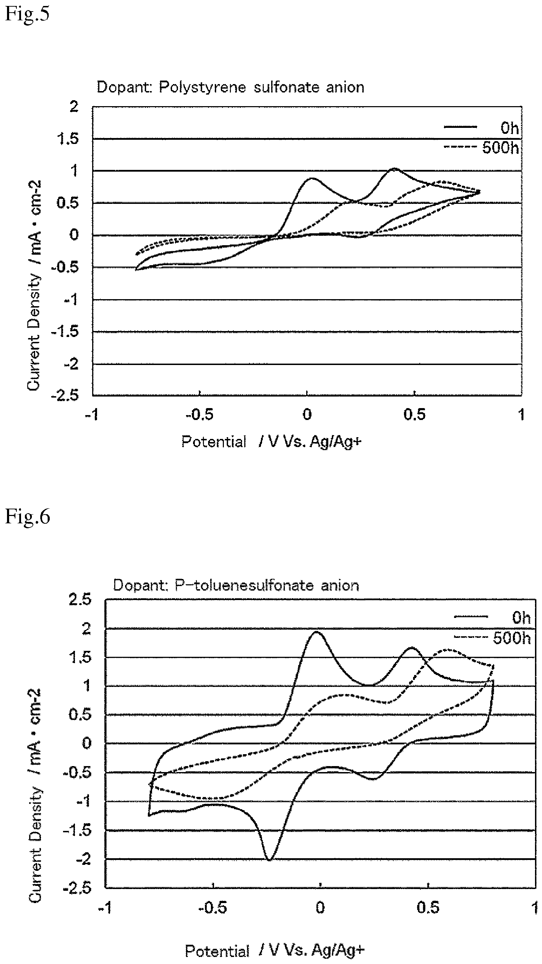

Figures 1 to 6 show cyclic voltammograms before and after thermal aging. Figures 1 to 6, in this order, show cyclic voltammograms of positive electrode A (dopant: borodisalicylate anion), positive electrode B (dopant: bis(trifluoromethanesulfonyl)imide anion), positive electrode C (dopant: bis(nonafluorobutanesulfonyl)imide anion), positive electrode D (dopant: 1,1,2,2,3,3-hexafluoro-1,3-disulfonylimide anion), positive electrode E (dopant: PSS anion) and positive electrode F (dopant: p-toluenesulfonate anion).

Before the thermal aging, two pairs of oxidation-reduction waves were observed in all the cyclic voltammograms of positive electrodes A to D and F. The oxidation-reduction wave on the negative potential side is an oxidation-reduction wave corresponding to I₃⁻/I⁻, and the oxidation-reduction wave on the positive potential side is an oxidation-reduction wave corresponding to I₂/I₃⁻. In a dye-sensitized solar cell, the reduction wave from I₃⁻ to I⁻ that was found around -0.2 V against the silver-silver chloride electrode is especially important, because sufficient reproduction of I⁻ is required. On the other hand, in the cyclic voltammogram of positive electrode E, no reduction wave from I₃⁻ to I⁻ was found, which is consistent with the finding in Non-Patent Document 1.

After the thermal aging, the shape of the cyclic voltammogram of positive electrode F with a PEDOT layer which contains p-toluenesulfonate anion as a dopant was greatly changed in that its current response remarkably decreased and the peak potentials of the oxidation waves shifted to the high electric potential side, while the peak potentials of the reduction waves shifted to the low electric potential side. This shows remarkable deterioration of oxidation-reduction catalytic activity. On the other hand, in the cyclic voltammograms of positive electrodes A to D, two pairs of oxidation-reduction waves were clearly observed even after the thermal aging. Especially, positive electrode A and positive electrode C showed almost the same cyclic voltammograms before and after the thermal aging under an extremely severe condition of 160 degrees centigrade for 500 hours, and had excellent heat resistance.

Therefore, it was concluded that the conductive polymer layer in the positive electrode used for a dye-sensitized solar cell of the present invention has excellent reduction catalytic activity to convert an oxidized species (I₃⁻) into a reduced species (I⁻) and, moreover, has more excellent heat resistance than the conductive polymer layer having an anion with a sulfonic acid group or sulfonic acid salt group as a dopant.

### (2) Evaluation of a dye-sensitized solar cell

### (i) Influence of the thickness of a PEDOT layer

### (a) Manufacture of a dye-sensitized solar cell

### Example 1

A polymerization solution in which the total amount of EDOT was dissolved in water was obtained by introducing 50 mL of distilled water into a glass container, adding to this 0.70 g (concentration: 0.10 M) of p-nitrophenol, 0.105 g (concentration: 0.0148 M) of EDOT, and 1.4 g (concentration: 0.08 M) of ammonium borodisalicylate in this order, and stirring it. Into the polymerization solution obtained, a Ti electrode composed of 100 µm thick Ti foil with an area of 2.25 cm² as a working electrode and a SUS mesh with an area of 5 cm² as a counter electrode were introduced, and galvanostatic electrolytic polymerization was carried out for 3 minutes under the condition of 100 µA/cm². After the working electrode after polymerization was washed by methanol, it was dried for 30 minutes at 150 degrees centigrade, and a positive electrode was obtained in which a PEDOT layer with the thickness of 105 nm (dopant: borodisalicylate anion) was formed on the Ti electrode. The density of the PEDOT layer was approximately 1.6 g/cm³.

Titanium oxide paste (manufacturer: JGC Catalysts and Chemicals Ltd.) was applied to the surface of an FTO electrode with an area of 0.25 cm² by screen printing method so that the thickness of the layer would be approximately 10 µm, was dried preliminarily for 30 minutes at 60 degrees centigrade, and then burned for 15 minutes at 450 degrees centigrade so that a titanium oxide porous layer was formed on the FTO electrode. The thickness of the titanium oxide after burning was about 8 µm. Further, by immersing the titanium oxide porous layer for 24 hours in a butanol/acetonitrile 1:1 solution containing pigment N719 at the concentration of 0.5 mM and drying it at room temperature, the titanium oxide porous layer was impregnated with the pigment N719, and a negative electrode of a dye-sensitized solar cell was obtained.

Then, by bonding together the negative electrode and the positive electrode obtained so that the titanium oxide porous layer and the conductive polymer layer faced each other through a 50 µm thick spacer, and by impregnating an electrolyte into the gap, an electrolytic layer was formed, and a dye-sensitized solar cell was obtained. For the electrolyte, a solution in which 0.1 M lithium iodide, 0.05 M iodine, 0.6M 1,2-dimethyl-3-propylimidazolium iodide, and 0.5 M 4-t-butylpyridine were dissolved in acetonitrile was used.

### Example 2

Into the polymerization solution used in Example 1, a Ti electrode composed of a 100 µm thick Ti foil with an area of 2.25 cm² as a working electrode and a SUS mesh with an area of 5 cm² as a counter electrode were introduced, and galvanostatic electrolytic polymerization was carried out for 10 minutes under the condition of 100 µA/cm². After the working electrode after polymerization was washed by methanol, it was dried for 30 minutes at 150 degrees centigrade, and a positive electrode was obtained in which a PEDOT layer with the thickness of 350 nm (dopant: borodisalicylate anion) was formed on the Ti electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 3

Into the polymerization solution used in Example 1, a Ti electrode composed of a 100 µm thick Ti foil with an area of 2.25 cm² as a working electrode and a SUS mesh with an area of 5 cm² as a counter electrode were introduced, and galvanostatic electrolytic polymerization was carried out for 6 minutes under the condition of 500 µA/cm². After the working electrode after polymerization was washed by methanol, it was dried for 30 minutes at 150 degrees centigrade, and a positive electrode was obtained in which a PEDOT layer with the thickness of 1050 nm (dopant: borodisalicylate anion) was formed on the Ti electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 4

Into the polymerization solution used in Example 1, a Ti electrode composed of a 100 µm thick Ti foil with an area of 2.25 cm² as a working electrode and a SUS mesh with an area of 5 cm² as a counter electrode were introduced, and galvanostatic electrolytic polymerization was carried out for 9 minutes under the condition of 500 µA/cm². After the working electrode after polymerization was washed by methanol, it was dried for 30 minutes at 150 degrees centigrade, and a positive electrode was obtained in which a PEDOT layer with the thickness of 1575 nm (dopant: borodisalicylate anion) was formed on the Ti electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 5

Into the polymerization solution obtained in Example 1, a Ti electrode composed of a 100 µm thick Ti foil with an area of 2.25 cm² as a working electrode and a SUS mesh with an area of 5 cm² as a counter electrode were introduced, and galvanostatic electrolytic polymerization was carried out for 12 minutes under the condition of 500 µA/cm². After the working electrode after polymerization was washed by methanol, it was dried for 30 minutes at 150 degrees centigrade, and a positive electrode was obtained in which a PEDOT layer with the thickness of 2100 nm (dopant: borodisalicylate anion) was formed on the Ti electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 6

Into the polymerization solution obtained in Example 1, a Ti electrode composed of a 100 µm thick Ti foil with an area of 2.25 cm² as a working electrode and a SUS mesh with an area of 5 cm² as a counter electrode were introduced, and galvanostatic electrolytic polymerization was carried out for 24 minutes under the condition of 500 µA/cm². After the working electrode after polymerization was washed by methanol, it was dried for 30 minutes at 150 degrees centigrade, and a positive electrode was obtained in which a PEDOT layer with the thickness of 4200 nm (dopant: borodisalicylate anion) was formed on the Ti electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 7

Titanium oxide paste (manufacturer: JGC Catalysts and Chemicals Ltd.) was applied to the surface of an FTO electrode with an area of 0.25 cm² by screen printing method with different thicknesses, was dried preliminarily for 30 minutes at 60 degrees centigrade, and then burned for 15 minutes at 450 degrees centigrade so that a titanium oxide porous layer with the thickness of 3 to 25 µm was formed on the FTO electrode. Further, by immersing the titanium oxide porous layer for 24 hours in a butanol/acetonitrile 1:1 solution containing pigment N719 at the concentration of 0.5 mM and drying it at room temperature, the titanium oxide porous layer was impregnated with the pigment N719, and a negative electrode of a dye-sensitized solar cell was obtained.

Then, the negative electrode was combined with the positive electrode with the PEDOT layer with the thickness of 1050 nm (dopant: borodisalicylate anion), which was obtained in Example 3, and a dye-sensitized solar cell was obtained through the same procedure as Example 1.

### Example 8

Into the polymerization solution used in Example 1, an FTO electrode with an area of 1 cm² (surface resistance of the FTO layer: 10Ω/□ as a working electrode and a SUS mesh with an area of 5 cm² as a counter electrode were introduced, and galvanostatic electrolytic polymerization was carried out for 10 minutes under the condition of 100 µA/cm². After the working electrode after polymerization was washed by methanol, it was dried for 30 minutes at 160 degrees centigrade, and a positive electrode was formed in which a PEDOT layer with the thickness of 350 nm (dopant: borodisalicylate anion) was formed on the FTO electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 9

Into the polymerization solution used in Example 1, an electrode composed with a polyethylene naphthalate/ITO sputtering film with an area of 2.25 cm² as a working electrode and a SUS mesh with an area of 5 cm² as a counter electrode were introduced, and galvanostatic electrolytic polymerization was carried out for 10 minutes under the condition of 100 µA/cm². After the working electrode after polymerization was washed by methanol, it was dried for 30 minutes at 160 degrees centigrade, and a positive electrode was obtained in which a PEDOT layer with the thickness of 350 nm (dopant: borodisalicylate anion) was formed on the polyethylene naphthalate/ITO electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Example 10

Into the polymerization solution used in Example 1, an FTO electrode with an area of 2.25 cm² (surface resistance of the FTO layer: 10Ω/□ as a working electrode and a SUS mesh with an area of 5 cm² as a counter electrode were introduced, and galvanostatic electrolytic polymerization was carried out for 10 minutes under the condition of 100 µA/cm². After the working electrode after polymerization was washed by methanol, it was dried for 30 minutes at 160 degrees centigrade, and a positive electrode was obtained in which a PEDOT layer with the thickness of 350 nm (dopant: borodisalicylate anion) was formed on the FTO electrode. The density of the PEDOT layer was approximately 1.6 g/cm³.

Then, the positive electrode was combined with the negative electrode with the titanium oxide porous layer impregnated with the pigment, which was obtained in Example 1, and a dye-sensitized solar cell was obtained through the same procedure as Example 1.

### Comparative Example 1

On a Ti electrode composed of Ti foil with the thickness of 100 µm and with an area of 2.25 cm², Pt was placed by vapor deposition with a sputtering method so that the thickness of Pt became approximately 100 nm, and a positive electrode in which a Pt layer was formed on the Ti electrode was obtained.

Then, the positive electrode was combined with the negative electrode with the titanium oxide porous layer with the thickness of 3 to 25 µm impregnated with the pigment, which was obtained in Example 7, and a dye-sensitized solar cell was obtained through the same procedure as Example 1.

### Comparative Example 2

225 µL of commercially available aqueous PEDOT:PSS dispersion (trade name: Baytron P, manufactured by H. C. Starck) was cast on a Ti electrode with an area of 2.25 cm² composed of Ti foil with the thickness of 100 µm and spin coating was carried out for 30 seconds at the rotation frequency of 5000 rpm. Then, it was dried at 150 degrees centigrade for 30 minutes and a positive electrode in which a PEDOT: PSS layer was formed on the Ti electrode was obtained.

Then, the positive electrode was combined with the negative electrode with the titanium oxide porous layer impregnated with the pigment, which was obtained in Example 1, and a dye-sensitized solar cell was obtained through the same procedure as Example 1.

### Comparative Example 3

100 µL of commercially available aqueous PEDOT: PSS dispersion (trade name: Baytron P, manufactured by H. C. Starck) was cast on an FTO electrode with an area of 1 cm² (surface resistance of the FTO layer: 10Ω/□ and spin coating was carried out for 30 seconds at the rotation frequency of 3000 rpm. Then, it was dried at 160 degrees centigrade for 30 minutes and a positive electrode with a PEDOT: PSS layer as described in Non-Patent Document 1 was obtained.

Then, the positive electrode was combined with the negative electrode with the titanium oxide porous layer impregnated with the pigment, which was obtained in Example 1, and a dye-sensitized solar cell was obtained through the same procedure as Example 1.

### Comparative Example 4

A commercially available product (trade name: A conductive film with a platinum coating, manufactured by Peccell Technologies, Inc.) in which a Pt coating layer was formed on an electrode with an area of 2.25 cm² composed of a polyethylene naphthalate/ITO sputtering film with a thickness of 200 µm was used as a positive electrode. The positive electrode was combined with the negative electrode with the titanium oxide porous layer impregnated with the pigment, which was obtained in Example 1, and a dye-sensitized solar cell was obtained through the same procedure as Example 1.

### Comparative Example 5

Pt was placed by vapor disposition on an FTO electrode with an area of 2.25 cm² (surface resistance of the FTO layer: 10Ω/□ so that the thickness of Pt would be approximately 350 nm, and a positive electrode in which a Pt layer was formed on the FTO electrode was obtained. Then, the positive electrode was combined with the negative electrode with the titanium oxide porous layer impregnated with the pigment, which was obtained in Example 1, and a dye-sensitized solar cell was obtained through the same procedure as Example 1.

### (b) Evaluation of a dye-sensitized cell

For the dye-sensitized solar cells in Examples 1 to 7 and Comparative Examples 1 and 2, current-voltage characteristics under the irradiation condition of 100 mW/cm² and AM 1.5 G by a solar simulator were evaluated. Evaluation was made at 20 degrees centigrade with the voltage changing at the speed of 10 mV/s.

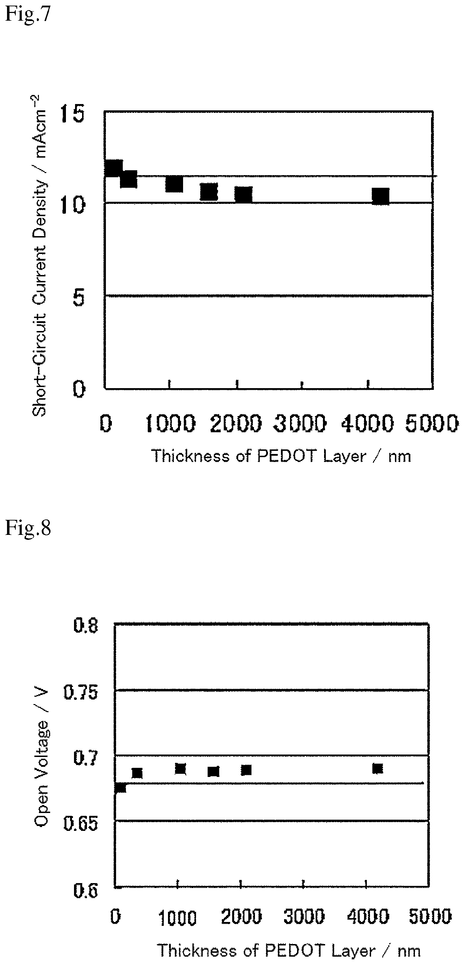

Figure 7 shows the relationship between the value of the short-circuit current density obtained and the thickness of the PEDOT layer of the positive electrode on the dye-sensitized solar cells of Examples 1 to 6. The figure shows that, as the thickness of the PEDOT layer grows, the value of the short-circuit current density gradually decreases, and when the thickness is 2100 nm or more, the value of the short-circuit current density is almost constant. Figure 8 shows the relationship between the value of the open voltage obtained and the thickness of the PEDOT layer of the positive electrode on the dye-sensitized solar cells of Examples 1 to 6. This shows that the value of the open voltage gradually increases as the thickness grows until the thickness of the PEDOT layer grows to be 1050 nm, and when the thickness becomes 1050 nm or more, the value of the open voltage obtained becomes almost the same.

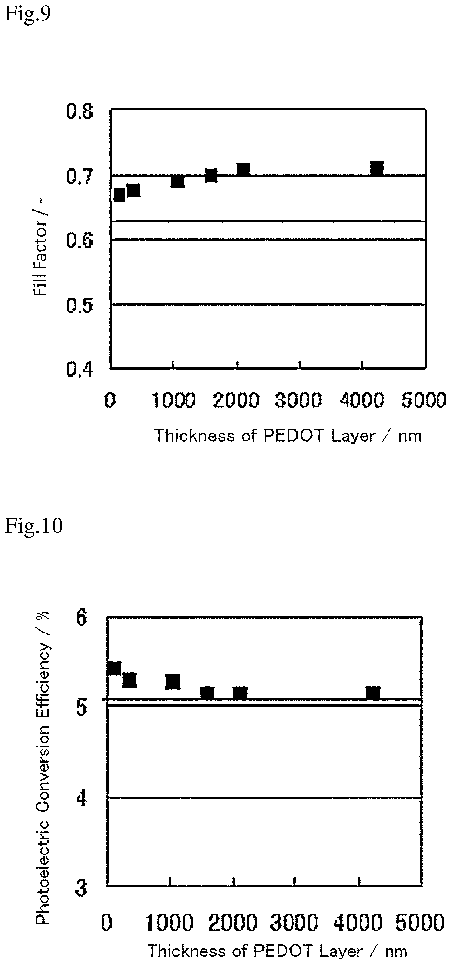

Figure 9 shows the relationship between the value of the fill factor obtained and the thickness of the PEDOT layer of the positive electrode on the dye-sensitized solar cells of Examples 1 to 6. It shows that the value of the fill factor gradually increases as the thickness of the PEDOT layer grows until the thickness becomes 2100 nm, and if the thickness is 2100 nm or more, the value of the fill factor is almost constant. Figure 10 shows the value of the photoelectric conversion efficiency calculated with the values of short-circuit current density, open voltage and fill factor shown in Figures 7 to 9. It shows that the value of the photoelectric conversion efficiency gradually decreases as the thickness of the PEDOT layer grows until the thickness becomes 1575 nm, and if the thickness is 1575 nm or more, the photoelectric conversion efficiency obtained is almost the same.

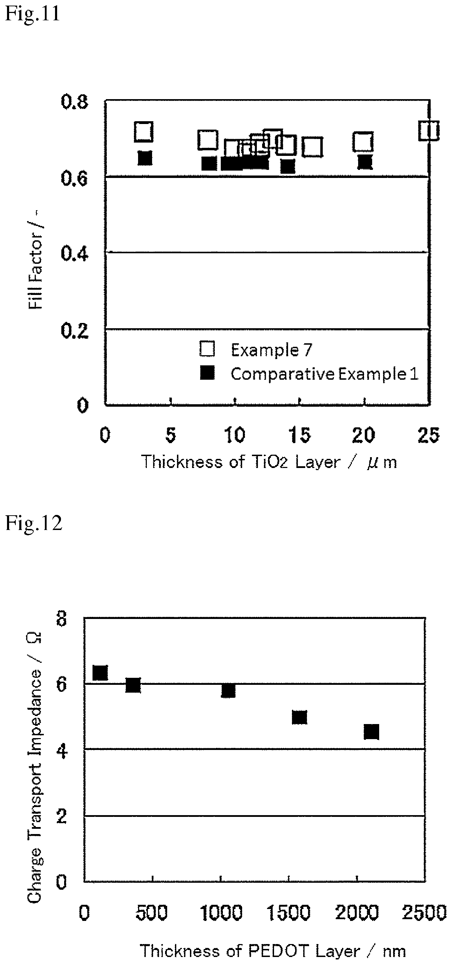

Figure 11 shows the relationship between the value of the fill factor obtained and the thickness of the titanium oxide porous layer of the negative electrode on the dye-sensitized solar cells of Example 7 and Comparative Example 1. It illustrates that the dye-sensitized solar cells in Example 7 and Comparative Example 1 show an almost constant value of fill factor irrespective of the thickness of the titanium oxide porous layer when the thickness of the titanium oxide porous layer is within the range of 3 to 20 µm. Also, it shows that the dye-sensitized solar cells in Example 7 shows higher values of fill factor than the dye-sensitized solar cells in Comparative Example 1 over the entire range of 3 to 20 µm with regard to the titanium oxide porous layer.

The value of the fill factor of the dye-sensitized solar cell having the positive electrode with the PEDOT: PSS layer in Comparative Example 2 was 0.22, which was remarkably small compared with the value of the fill factor in the battery of Examples 1 to 6 and Comparative Example 1.

The straight lines in Figures 7 to 10 show the value of short-circuit current density, open voltage, fill factor and photoelectric conversion efficiency, respectively, on the dye-sensitized solar cell of Comparative Example 1 which has a titanium oxide porous layer of 8 µm. It shows that the dye-sensitized solar cells of Examples 1 to 6 of the present invention show especially increased fill factor compared with the dye-sensitized solar cell having the positive electrode with the Pt layer of Comparative Example 1, showing this fill factor brings high photoelectric conversion efficiency to the batteries.

To investigate this result, charge transfer impedance in the I⁻/I₃⁻ oxidation-reduction reaction was calculated by measuring electrochemical impedance on the dye-sensitized solar cells of the Examples. The charge transport impedance in the I⁻/I₃⁻ oxidation-reduction reaction constitutes the most part of the predominant factor for fill factor of a dye-sensitized solar cell. Figure 12 shows the result. As is evident from this figure, the charge transport impedance decreased as the thickness of the PEDOT layer increased. It was considered that I₃⁻ reached a deep part of the layer (near the Ti electrode) and reduced to I⁻ even if the PEDOT layer was thick.

To confirm this, electrochemical response in an I⁻/I₃⁻ electrolyte was measured with a cyclic voltammogram at a low scanning speed. A positive electrode used for the dye-sensitized solar cell of any of the Examples 1 to 6, a platinum mesh with an area of 4 cm² as a counter electrode, and a silver-silver chloride electrode as a reference electrode were introduced into an electrolyte in which 10 mM lithium iodide, 1mM iodine, 1 M lithium tetrafluoroborate was dissolved into acetonitrile, and the cyclic voltammogram was evaluated with the scanning potential range of -0.8 to +0.8 and with the scanning speed of 1 mV/s. Then, the area with the current density of 0 mA/cm⁻² or less and with electric potential of -0.05 to -0.20 V in the cyclic voltammogram obtained was calculated as a reduction charge. The value of the reduction charge is in proportion to the number of active sites in the reduction reaction from I₃⁻ to I⁻, and therefore, in proportion to the specific surface area of the PEDOT layer engaging in the reaction.

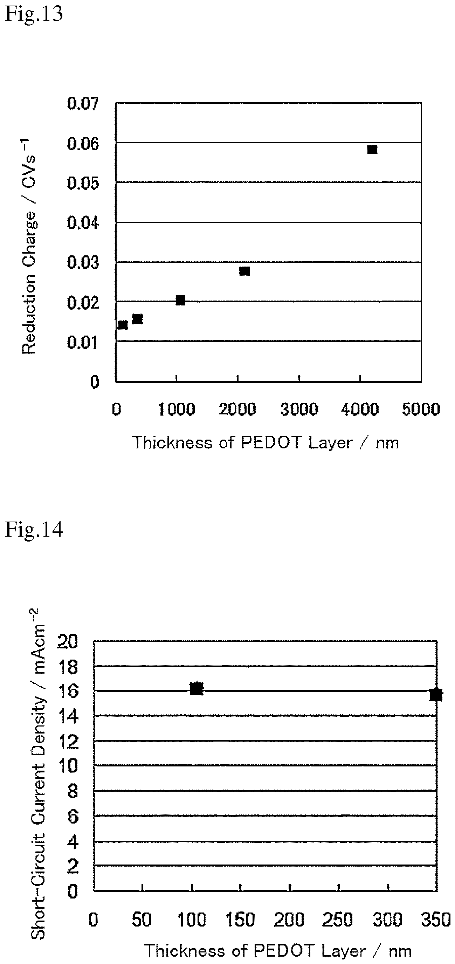

Figure 13 shows the result. As the thickness of the PEDOT layer increased, the value of the reduction charge increased, and when the thickness was 2100 nm or more, the growth rate of the reduction charge further increased. It was found from the result that the number of active sites in the reduction reaction from I₃⁻ to I⁻ increased as the thickness of the PEDOT layer increased. In other words, it was found that I₃⁻ reached a deep part of the layer and was reduced to I⁻ if the thickness of the PEDOT layer was as thick as 4200 nm. It was concluded that this is the reason why the value of the fill factor of the dye-sensitized solar cell increases as the thickness of the PEDOT layer increases.

Moreover, the electrode reaction speeds of a conductive polymer layer in a positive electrode of the dye-sensitized solar cell in the present invention and a Pt layer in a positive electrode of a conventional dye-sensitized solar cell were compared in the following method. A positive electrode used for the dye-sensitized solar cell in Example 10 or a positive electrode used for the dye-sensitized solar cell in Comparative Example 5, a platinum mesh with an area of 4 cm² as a counter electrode, and a silver-silver chloride electrode as a reference electrode were introduced into an electrolyte in which 10 mM lithium iodide, 1 mM iodine and 1 M lithium tetrafluoroborate were dissolved in acetonitrile, and a cyclic voltammogram was measured with the scanning potential range of -0.55 to +0.25 V and with varying scanning speeds. Within the range of -0.55 to +0.25 V, the I⁻/I₃⁻ oxidation-reduction reaction occurs. Then, the rate constant of the electrode reaction was calculated based on Nicolson's theory from the scanning speed and the potential difference between the peak potential of an oxidation wave and the peak potential of a reduction wave. It was found that the positive electrode used for the dye-sensitized solar cell in Example 10 showed the rate constant of 2.83 ^{∗} 10⁻³ cms⁻¹, while the positive electrode used for the dye-sensitized solar cell in Comparative Example 5 showed the rate constant of 2.61 ^{∗} 10⁻³ cms⁻¹. That is, it was found that the conductive polymer layer in the positive electrode of the dye-sensitized solar cell in the present invention had higher responsiveness with iodine than the Pt layer in the positive electrode of the conventional dye-sensitized solar cell. This is also considered to be a reason why the dye-sensitized solar cell of the present invention shows higher photoelectric conversion efficiency compared with a conventional dye-sensitized solar cell having a positive electrode with a Pt layer.

Dye-sensitized solar cells of Examples 1 to 6 and Comparative Example 1 were left at 85 degrees centigrade for 1000 hours without light irradiation. After this test, photoelectric conversion efficiency was measured again. As a result, every battery showed approximately 97 % of the initial photoelectric conversion efficiency. This shows that the conductive polymer layer in the positive electrode used for the dye-sensitized solar cell in the present invention was stable and was not influenced by water content in air while it was left unattended.

Dye-sensitized solar cells of Example 8 and Comparative Example 3 were left at 60 degrees centigrade for 500 hours under the irradiation condition of 100 mW/cw² and AM 1.5 G by a solar simulator, and photoelectric conversion efficiency before and after this test was measured. The dye-sensitized solar cell of Example 8 showed photoelectric conversion efficiency of 6.7 % at an early stage (before the test) and 6.6 % after the test, and there was little influence from leaving the cell under the above condition, but the dye-sensitized solar cell of Comparative Example 3 showed photoelectric conversion efficiency of 3 % at an early stage, whereas photoelectric conversion after the test was significantly reduced to 0.3 %. This shows that the conductive polymer layer in the positive electrode of the dye-sensitized solar cell in the present invention is also stable, is not influenced by water content in air under irradiation, and has remarkably enhanced durability compared with a conventional PEDOT: PSS layer.

Dye-sensitized solar cells of Example 9 and Comparative Example 4 were left at 85 degrees centigrade with relative humidity of 85 % for 320 hours without light irradiation, and photoelectric conversion efficiency before and after this test was measured. The dye-sensitized solar cell of Example 9 showed 86 % of the initial value of photoelectric conversion efficiency, but the dye-sensitized solar cell of Comparative Example 4 showed only 68 % of the initial value of photoelectric conversion efficiency. This shows that the conductive polymer layer in the positive electrode of the dye-sensitized solar cell in the present invention has excellent durability at high temperature and high humidity compared with a conventional Pt layer.

### (ii) Influence of the manufacturing process of a titanium oxide porous layer

### (a) Manufacture of a dye-sensitized solar cell

### Example 11

A polymerization solution in which the total amount of EDOT was dissolved in water was obtained by introducing 50 mL of distilled water into a glass container, adding to this 0.70 g (concentration: 0.10 M) of p-nitrophenol, 0.105 g (concentration: 0.0148 M) of EDOT, and 1.4 g (concentration: 0.08 M) of ammonium borodisalicylate in this order, and stirring it. An FTO electrode with an area of 2.25 cm² as a working electrode and a SUS mesh with an area of 5 cm² as a counter electrode were introduced into the polymerization solution obtained, and galvanostatic electrolytic polymerization was carried out for 3 minutes or 10 minutes under the condition of 100 µA/cm². After the working electrode after polymerization was washed by water and methanol, it was dried for 30 minutes at 150 degrees centigrade, and a positive electrode was obtained in which a PEDOT layer with the thickness of 105 nm or 350 nm (dopant: borodisalicylate anion) was formed on the FTO electrode. The density of the PEDOT layer was approximately 1.6 g/cm³.

On the surface of an FTO electrode with an area of 0.25 cm², titanium oxide paste (manufactured by JGC Catalysts and Chemicals Ltd.) was applied by screen printing method and dried preliminarily for 20 minutes at 120 degrees centigrade. Further, by repeating twice the application of the above-mentioned titanium oxide paste by screen printing method on a titanium oxide layer obtained and preliminarily drying it for 20 minutes at 120 degrees centigrade, a titanium oxide layer with the thickness of a total of 14 ± 1 µm was formed. Further, by burning it for 15 minutes at 450 degrees centigrade, a titanium oxide porous layer was formed on the FTO electrode. Further, by immersing the titanium oxide porous layer for 24 hours in a t-butanol/acetonitrile 1:1 solution containing pigment N719 at the concentration of 0.5 mM and drying it at room temperature, the titanium oxide porous layer was impregnated with the pigment N719, and a negative electrode of a dye-sensitized solar cell was obtained.

Then, by bonding together the negative electrode and the positive electrode obtained so that the titanium oxide porous layer and the conductive polymer layer faced each other through a 50-µm-thick spacer, and by impregnating an electrolyte into the gap, an electrolytic layer was formed, and a dye-sensitized solar cell was obtained. For the electrolyte, a solution in which 0.1 M lithium iodide, 0.05 M iodine, 0.6 M 1,2-dimethyl-3-propylimidazolium iodide, and 0.5 M 4-t-butylpyridine were dissolved in acetonitrile was used.

### (b) Evaluation of a dye-sensitized solar cell

The current-voltage characteristics of a dye-sensitized solar cells in Example 11 were evaluated under the irradiation condition of 100 mW/cw² and AM 1.5 G by a solar simulator. The evaluation was made at 20 degrees centigrade with the voltage changing at the speed of 10 mV/s.

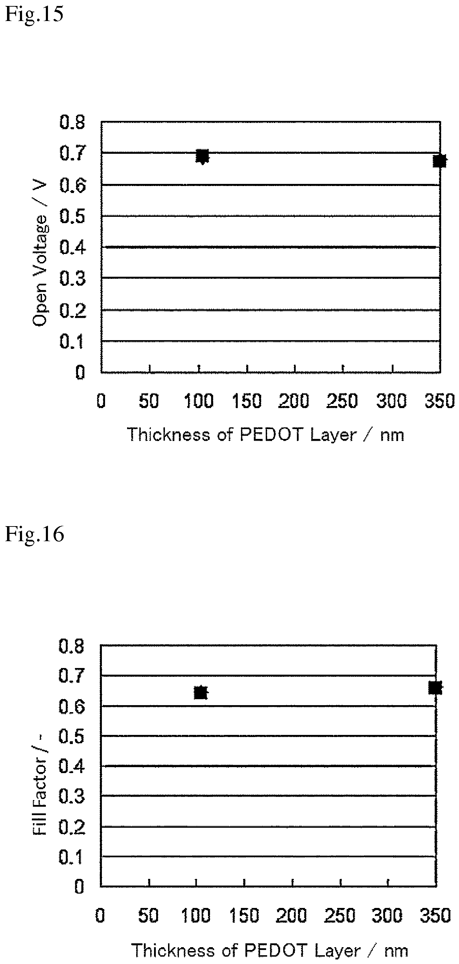

Figures 14, 15, 16, and 17 show the relationship between the thickness of the PEDOT layer and short-circuit current density, open voltage, fill factor and photoelectric conversion efficiency, respectively, on the dye-sensitized solar cells of Example 11.

From a comparison of the results shown in Figures 14 to 17 for the batteries of Example 11 and the results shown in Figures 7 to 10 for the batteries of Examples 1 to 6, both showed the same result in that the values of the short-circuit current density and the photoelectric conversion efficiency decrease while the value of the fill factor increases as the thickness of a PEDOT layer increases. The batteries of Example 11 showed high values of open voltage even when the thickness of the PEDOT layer was 105 nm.

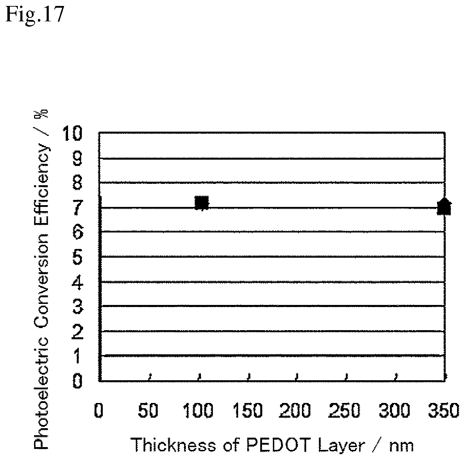

From a comparison of the results for the batteries of Example 11 and the results for the batteries of Examples 1 to 6, there is a remarkable difference in the value of short-circuit current density and the value of photoelectric conversion efficiency. As is evident from the contrast between Figure 14 and Figure 7, the batteries of Example 11 showed remarkably increased values of short-circuit current density compared with the batteries of Examples 1 to 6 and, as is evident from the contrast between Figure 17 and Figure 10, the batteries of Example 11 showed photoelectric conversion efficiencies which were improved by as much as approximately 2 % compared with the batteries of Examples 1 to 6. It is considered that the even, thick titanium oxide porous layer was able to be formed by performing the application of titanium oxide paste and preliminary drying process more than once in producing a negative electrode in the battery of Example 11, the short-circuit current density was improved, and thus the photoelectric conversion efficiency was significantly improved.

### INDUSTRIAL APPLICABILITY

The present invention gives a dye-sensitized solar cell with high heat resistance and high conversion efficiency.

## Claims

1. A dye-sensitized solar cell comprising:
a negative electrode having a semiconductor layer with a pigment as a photosensitizer,
an electrolyte layer located on the semiconductor layer of the negative electrode having a paired oxidized species and reduced species; and
a positive electrode located on the electrolyte layer having a conductive polymer layer that acts as a catalyst to convert the oxidized species into the reduced species,
wherein the conductive polymer layer in the positive electrode comprises:
a polymer derived from at least one monomer selected from the group consisting of 3,4-disubstituted thiophenes; and
an anion as a dopant to the polymer generated from at least one organic non-sulfonate compound having an anion with the molecular weight of 200 or more, and
the thickness of the conductive polymer layer is within the range of 100 to 10000 nm, and **characterised in that** the density of the conductive polymer layer is within the range of 1.15 to 1.80 g/cm³.

2. The dye-sensitized solar cell according to claim 1, wherein the semiconductor layer in the negative electrode is formed by titanium oxide.

3. The dye-sensitized solar cell according to claim 1 or 2, wherein the thickness of the semiconductor layer is within the range of 3 to 20 µm.

4. The dye-sensitized solar cell according to any of claims 1 to 3, wherein the organic non-sulfonate compound is at least one compound selected from the group consisting of a sulfonylimidic acid of the formula (I) or the formula (II) 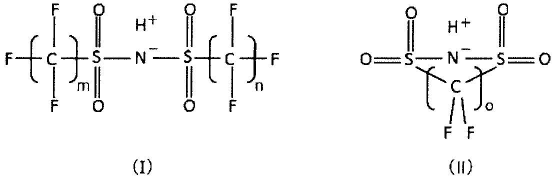 where m is an integer from 1 to 8, n is an integer from 1 to 8, and o is an integer 2 or 3, and salts thereof.

5. The dye-sensitized solar cell according to any of claims 1 to 3, wherein the organic non-sulfonate compound is at least one compound selected from the group consisting of borodisalicylic acid and borodisalicylic salts.

6. The dye-sensitized solar cell according to any of claims 1 to 5, wherein the monomer is 3,4-ethylenedioxythiophene.

## Patentansprüche

1. Farbstoffsolarzelle, umfassend:
eine negative Elektrode mit einer Halbleiterschicht mit einem Pigment als Photosensibilisator;
eine Elektrolytschicht, die sich auf der Halbleiterschicht der negativen Elektrode befindet, mit paarweisen oxidierten Spezies und reduzierten Spezies; und
eine positive Elektrode, die sich auf der Elektrolytschicht befindet, mit einer leitfähigen Polymerschicht, die als Katalysator wirkt, um die oxidierten Spezies in die reduzierten Spezies umzuwandeln,
wobei die leitfähige Polymerschicht in der positiven Elektrode umfasst:
ein Polymer, das von mindestens einem Monomer hergeleitet ist, das aus der Gruppe ausgewählt ist, die aus 3,4-disubstituierten Thiophenen besteht; und
ein Anion als Dotierstoff für das Polymer, das von mindestens einer organischen Nicht-Sulfonat-Verbindung mit einem Anion mit dem Molekulargewicht von 200 oder mehr erzeugt wurde, und
die Dicke der leitfähigen Polymerschicht im Bereich von 100 bis 10000 nm liegt, und **dadurch gekennzeichnet, dass**
die Dichte der leitfähigen Polymerschicht im Bereich von 1,15 bis 1,80 g/cm³ liegt.

2. Farbstoffsolarzelle gemäß Anspruch 1, wobei die Halbleiterschicht in der negativen Elektrode durch Titanoxid gebildet ist.

3. Farbstoffsolarzelle gemäß Anspruch 1 oder 2, wobei die Dicke der Halbleiterschicht im Bereich von 3 bis 20 µm liegt.

4. Farbstoffsolarzelle gemäß einem der Ansprüche 1 bis 3, wobei die organische Nicht-Sulfonat-Verbindung mindestens eine Verbindung ist, die aus der Gruppe ausgewählt ist, bestehend aus einer Sulfonylimidsäure der Formel (I) oder der Formel (II) 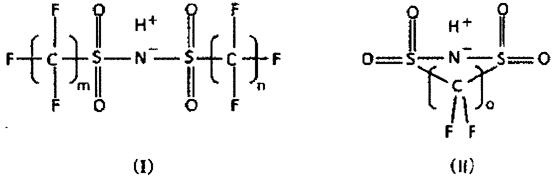 wobei m eine ganze Zahl von 1 bis 8 ist, n eine ganze Zahl von 1 bis 8 ist und o eine ganze Zahl 2 oder 3 ist, und Salzen davon.

5. Farbstoffsolarzelle gemäß einem der Ansprüche 1 bis 3, wobei die organische Nicht-Sulfonat-Verbindung mindestens eine Verbindung ist, die aus der Gruppe ausgewählt ist, die aus Bordisalicylsäure und Bordisalycilsalzen besteht.

6. Farbstoffsolarzelle gemäß einem der Ansprüche 1 bis 5, wobei das Monomer 3,4-Ethylendioxythiophen ist.

## Revendications

1. Cellule solaire à colorant comprenant :
une électrode négative ayant une couche semi-conductrice avec un pigment servant de photo sensibilisant,
une couche d'électrolyte située sur la couche semi-conductrice de l'électrode négative ayant une espèce oxydée et une espèce réduite appariées ; et
une électrode positive située sur la couche d'électrolyte ayant une couche polymère conductrice qui sert de catalyseur pour convertir les espèces oxydées en espèces réduites,
dans laquelle la couche polymère conductrice dans l'électrode positive comprend:
un polymère dérivé d'au moins un monomère choisi dans le groupe constitué de 3,4-thiophènes disubstitués ; et
un anion servant de dopant pour le polymère généré à partir d'au moins un composé organique non sulfonate ayant un anion avec le poids moléculaire de 200 ou plus, et
l'épaisseur de la couche polymère conductrice étant dans la plage de 100 à 10000 nm, et
**caractérisée en ce que**
la masse volumique de la couche polymère conductrice est dans la plage de 1,15 à 1,80 g/cm³.

2. Cellule solaire à colorant selon la revendication 1, dans laquelle la couche semi-conductrice dans l'électrode négative est formée par de l'oxyde de titane.

3. Cellule solaire à colorant selon la revendication 1 ou la revendication 2, dans laquelle l'épaisseur de la couche semi-conductrice est dans la plage de 3 à 20 µm.

4. Cellule solaire à colorant selon l'une quelconque des revendications 1 à 3, dans laquelle le composé organique non sulfonate est au moins un composé choisi dans le groupe constitué d'un acide sulfonyl imidique selon la formule (I) ou la formule (II) 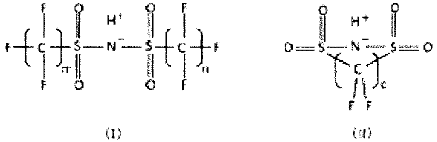 dans laquelle m est un nombre entier de 1 à 8, n est un nombre entier de 1 à 8, et o est un nombre entier égal à 2 ou 3, et des sels de ceux-ci.

5. Cellule solaire à colorant selon l'une quelconque des revendications 1 à 3, dans laquelle le composé organique non sulfonate est au moins un composé choisi dans le groupe constitué de l'acide boro disalicylique et de sels boro disalicyliques.

6. Cellule solaire à colorant selon l'une quelconque des revendications 1 à 5, dans laquelle le monomère est le 3,4-éthylène dioxy thiophène.
